Europäisches Patentamt

European Patent Office

Office européen des brevets

(19)

(11) Publication number: **0 601 541 A2**

# EUROPEAN PATENT APPLICATION

(21) Application number: **93119697.6**

(22) Date of filing: **07.12.93**

(51) Int. Cl.5: **H01L 29/812**

(30) Priority: **08.12.92 JP 328257/92**

(43) Date of publication of application:
**15.06.94 Bulletin 94/24**

(84) Designated Contracting States:
**DE DK FR GB NL SE**

(71) Applicant: **SUMITOMO ELECTRIC INDUSTRIES,
LIMITED**
**5-33, Kitahama 4-chome**
**Chuo-ku**
**Osaka 541(JP)**

(72) Inventor: **Nakajima, Shigeru, c/o Yokohama
Works Sumitomo
Elec.Ind.Ltd,
1, Taya-cho,
Sakae-ku
Yokohama-shi, Kanagawa(JP)**

(74) Representative: **Kahler, Kurt, Dipl.-Ing.
Patentanwälte Kahler, Käck & Fiener
Maximilianstrasse 57
Postfach 12 49
D-87712 Mindelheim (DE)**

(54) **Compound semiconductor device and method for fabricating the same.**

(57) This invention relates to a compound semiconductor device with an innovational recess structure which can improve characteristics. An insulating film (17) with an opening ($P_1$) formed in a portion thereof is formed on a cap layer (14) provided on a donor supply layer (13). The cap layer (14) is etched through the opening ($P_1$), whereby the recess structure which is extended into the donor supply layer (13) and a wider etched space than an area of the opening ($P_1$) is formed. In the recess structure there is formed by vacuum vaporization a Schottky gate electrode (18) which is in Schottky junction only with the donor supply layer (13), extended upward through the opening ($P_1$) and overlapped on a portion of the upper surface of the insulating film (17). The Schottky gate electrode (18) tightly shields the interior of the recess structure from outside ambient atmosphere. As a result, a problem that impurities intrude into a portion of the donor supply layer (13) exposed in the recess structure and deteriorate electric characteristics, can be redressed.

Fig. 1

## BACKGROUND OF THE INVENTION

It is disclosed in various references, e.g., A. Fathimulla et al., "High-Performance InAlAs/InGaAs HEMT's and MESFET`s", IEEE ELECTRON DEVICE LETTERS, vol. 9, No. 7, July 1988, ps. 328-330; Shinobu Fujita et al., "InGaAs/InAlAs HEMT with a Strained InGaP Schottky Contact Layer", IEEE ELECTRON DEVICE LETTERS, vol. 14, No. 5, May 1993,ps 259-261; and Japanese Patent Laid-Open Publication No. 160161/1993 that materials lattice-matched on InP substrates, or materials which do not lattice-match on InP substrates but are grown in a thickness below a critical film thickness, which do not incur, i.e., compounds such as InP, $Ga_{1-x}As$, etc., are suitable to realize high speed high frequency semiconductor devices.

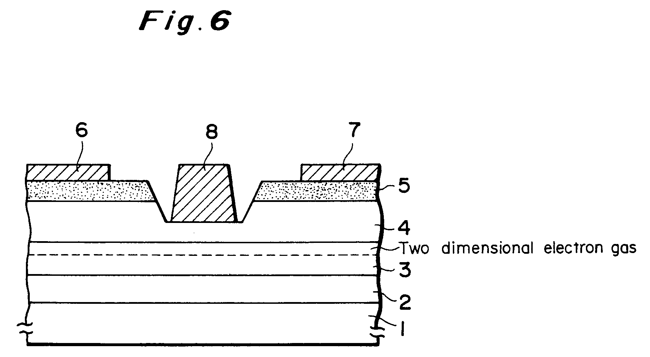

The schematic structure of the HEMT's disclosed in these references comprises, as exemplified in Fig. 6, on a semi-insulating InP substrate 1 a non-doped InAlAs buffer layer 2, an InGaAs channel layer 3, an n-InAlAs donor supply layer 4, a heavily doped n-type InGaAs cap layer 5, source and drain ohmic electrodes 6, 7 vaporized on the upper surface of the cap layer 5. This structure further comprises a Schottky gate electrode 8 vaporized in Schottky junction with the donor supply layer in a recess structure which is formed by etching the cap layer 5 down to the donor supply layer 4.

## SUMMARY OF THE INVENTION

This invention relates to a compound semiconductor device having a structure in which a Schottky gate is formed on a donor supply layer through a recess structure. Specifically an object of this invention is to provide a compound semiconductor device of an innovational structure which can further improve characteristics.

To achieve the object, the compound semiconductor device according to this invention comprises an insulating film with an opening in a portion thereof, which is formed on a cap layer formed on a donor supply layer, and a Schottky gate electrode being in Schottky junction with the donor supply layer by vacuum vaporization in a recess structure etched wider than an open area of the opening, extended upward through the recess structure and overlapped on an outside periphery of the opening.

In this structure, since the recess structure has a wider space in the cap layer than an open area of the opening in the insulating film, vacuum spaces between the cap layer and the side walls of the Schottky gate electrode. Accordingly the Schottky gate electrode is not in direct Schottky junction with the cap layer and in Schottky junction only with the donor supply layer. Thus gates of semiconductor devices, such as HEMT's and MESFET's, can be realized. Since the Schottky gate electrode is overlapped on an outside peripheral portion of the opening in the insulating film, the spaces in the recess structure can be tightly shielded from the outside in a vacuum condition. As a result, a problem that impurities intrude into a portion of the donor supply layer in the recess structure with a result of deteriorated electric characteristics can be prevented. To be specific, in compound semiconductor devices of the conventional recess structures, since the recess structures are exposed to the outside ambient atmosphere, portions of the donor supply layers are exposed to the outside ambient atmosphere. Accordingly in the semiconductor fabrication processes, the exposed portions (peripheral portions of the Schottky gate electrodes) are oxidized with a result of deteriorated electric characteristics. But the recess structure according to this invention never incurs such problem.

This invention is widely applicable to various compound semiconductor devices, such as HEMT's and MESFET's with recess structures for Schottky gate electrodes. The recess structure according to this invention is not limited to applications in specific compound semiconductors but is widely applicable to compound semiconductor devices formed of various compound semiconductors. The formation of the recess structure according to this invention does not need complicated and specific fabrication steps and accordingly this invention can be easily practiced. Thus this invention can produce excellent advantageous effects.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

## BRIEF DESCRIPTION OF THE DRAWINGS

Fig. 1 is a plan layout view and vertical sectional view of the compound semiconductor device according to a first embodiment of this invention;

Figs. 2A to 2D are vertical sectional views of the compound semiconductor device according to the first embodiment in the respective steps of its fabrication process;

Fig. 3 is a vertical sectional view of the modification of the first embodiment shown in Figs. 2A to 2D;

Fig. 4 is a vertical sectional view of the compound semiconductor device according to a second embodiment of this invention;

Fig. 5 is a vertical sectional view of the compound semiconductor device according to a third embodiment of this invention; and

Fig. 6 is a vertical sectional view of a conventional compound semiconductor device.

## DESCRIPTION OF THE PREFERRED EMBODIMENT

### Embodiment 1

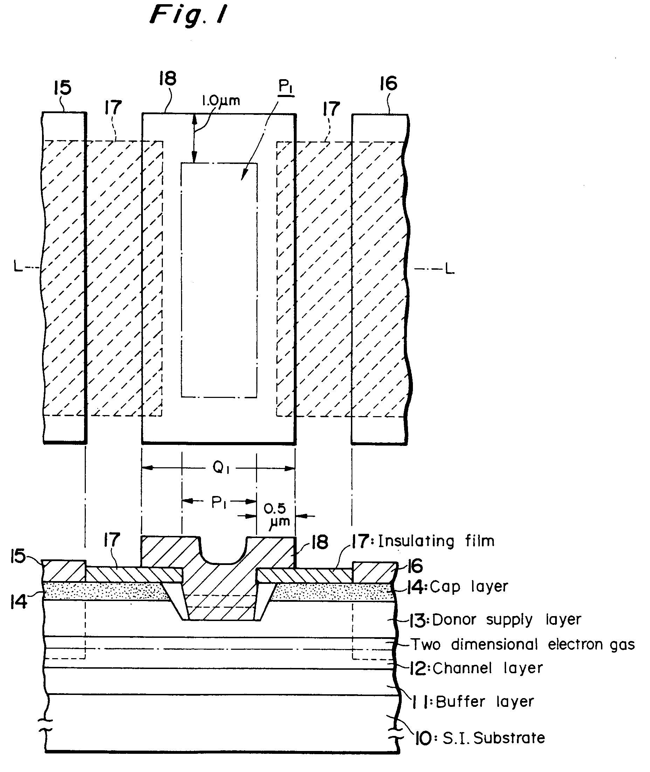

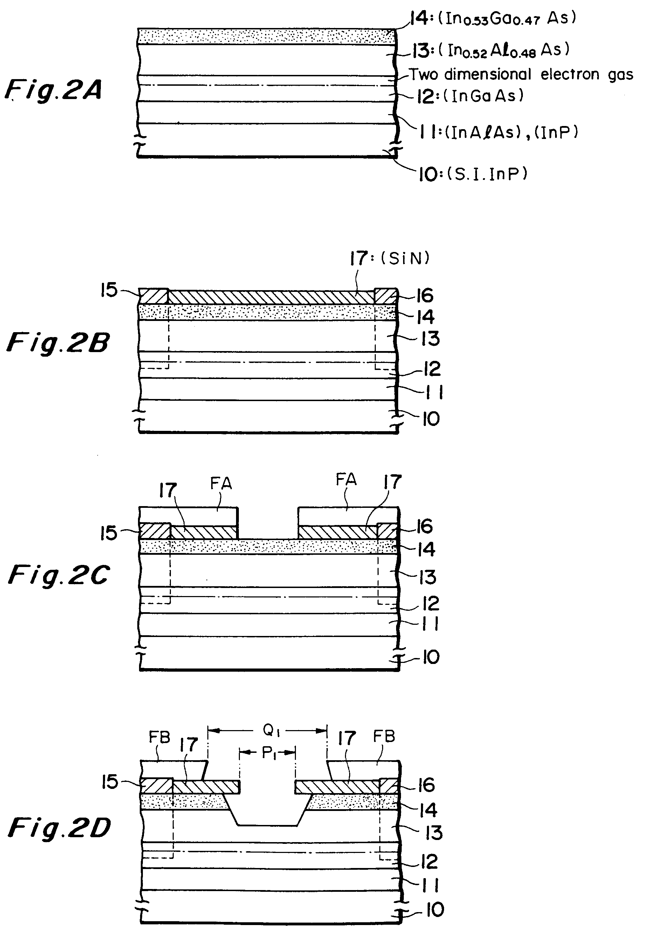

A HEMT as the compound semiconductor device according to a first embodiment of this invention will be explained with reference to Figs. 1 and 2A to 2D. Fig. 1 is a plan view (upper drawing) of a major portion of the HEMT, and a vertical sectional view (lower drawing) along the phantom line L-L in Fig. 1. Figs. 2A to 2D are views of the steps of the HEMT fabrication.

The structure of the major portion will be explained with reference to Fig. 1. On a semi-insulating InP substrate 10 there are formed buffer layer 11 of undoped InP or InAlAs which is lattice-matches with InP, an InGaAs channel layer 12, an n-type InAlAs donor supply layer 13, and a heavily doped n-type InGaAs cap layer 14 in the stated order. Further a drain and a source ohmic electrodes 15, 16 are vaporized on set regions on the cap layer 14, and heavily doped n-type layers (the regions indicated by the dot lines in Fig. 1) are formed below the ohmic electrodes 15 and 16 by alloying.

An insulating film 17 of SiN is formed on a rest portion of the cap layer 14 except regions with the ohmic electrodes 15, 16 formed on, and a region with a Schottky gate electrode 18 formed in (a region for an opening P1 which will be explained later). In the region with the Schottky gate electrode in (a region between the drain and source) there is formed, because of the partial absence of the insulating film 17, a rectangular opening P1, and a recess structure which corresponds to the opening P1 and arrives down at a portion of an upper portion of the donor supply layer 13 through the cap layer 14. In the recess structure the Schottky electrode 18 which is in Schottky junction with the donor supply layer 13 is vacuum vaporized.

The Schottky electrode 18 partially contacts with the donor supply layer 13 and is extended without contact with the cap layer 14 upward through the opening P1 to overlap portions of the upper surface of the insulating film 17 outside the opening P1.

Then, an example of the fabrication process of the HEMT having such structure will be explained, referring to Figs. 2A-2D. In the first step of the process shown in Fig. 2A, the buffer layer 11 formed of undoped InP or InAlAs which is lattice-matched with InP, is deposited on the substrate 10 formed of semi-insulating InP with about 3000 Å thickness by Molecular Beam Epitaxy method (MBE) or Organic Metallic Vapor Phase Epitaxy method (OMVPE). Next a channel layer 12 formed of InGaAs is deposited on the buffer layer 11 with about 150 Å thickness. Further, the doner supply layer 13 formed of $In_{0.52}Al_{0.48}As$ having a electron concentration of $5\times10^{18}/cm^3$ is deposited on the channel layer 12 with about 400 Å thickness. The cap layer 14 formed of $In_{0.53}Ga_{0.47}As$ having an electron concentration of $5\times10^{18}/cm^3$ is formed on the doner supply layer 13 with about 100 Å thickness. The material of the channel layer may be InP.

Next, in the second step shown in Fig. 2B, the drain and source ohmic electrodes 15 and 16 are evaporated on a predetermined area of the cap layer 14 and the high density n-type layer is formed under the ohmic electrodes 15 and 16 by alloy process. Next, the insulating layer 17 formed of SiN is formed with about 500 Å - 1000 Å thickness. Although such SiN insulating layer can be formed at relatively low temperature, an insulating material e.g., $SiO_2$ or SiON which can be formed at temperature lower than that of SiN may be used.

Next, in the third step shown in Fig. 2C, a portion of the insulating film 17 for the opening P1 to be formed therein is removed using a photoresist FA by the known photolithography. That is, the opening P1 is the mask for the recess etching, which will be explained later and defines a channel length and width of the gate. After the opening P1 is formed the photoresist FA is removed.

Next, in the fourth step shown in Fig. 2D, a photoresist FB is formed again by the known photolithography on a rest region other than a region Q1 including the opening P1. As shown in Fig. 1, the region Q1 is larger than the opening each by 0.5 $\mu$m in the direction of length of the gate and each by 1.0 $\mu$m in the direction of width of the gate. Thus, after the photoresist FB is formed, the cap layer is recess-etched down to the donor supply layer 13 with the insulating film 17 and the photoresist FB as the mask.

In the recess etching, aqueous phosphoric acid solution and hydrogen peroxide solution are used as etchant. This recess etching forms, as shown, the recess structure corresponding to the opening P1 as shown in Fig. 2D, and the cap layer 14 is etched more widthwise than the opening P1 of the insulating film 17. Accordingly the space formed in the cap layer 14 by this recess structure is wider than the opening P1 of the insulating film 17.

Then, Ti/Pt/Au are vacuum vaporised sequentially in respective 500 Å/500 Å/5000 Å thicknesses so as to cover the opening P1 and the region Q1. Then an unnecessary portion of the photoresist FB is lifted off to form the Schottky gate electrode 18 as shown in Fig. 1. Since this vacuum vaporization forms the Schottky gate electrode 18 in a rectangular sectional shape contour to the opening P1 in the insulating film 17, the Schottky gate electrode 18 is in contact with the donor supply layer 13 but out of contact with the cap layer 14 which is etched up to portions inner of the opening P1. Since the unnecessary photoresist FB has been lifted off, the Schottky electrode 18 is vaporized onto the region Q1 partially on the upper surface of the insulating film 17. Thus the opening P1 is tightly closed by the overlapping Schottky gate electrode 18 on the portion of the insulating film 17, and an interior space of the recess structure is perfectly shielded from outside ambient atmosphere.

Thus, in the first embodiment, as shown in Fig. 1, the Schottky electrode 18 covers a portion of the insulating film 17 and contacts with the donor supply layer 13. Accordingly the Schottky electrode 18 itself can shield the recess structure from the outside to thereby expel causes for deterioration of electric characteristics, such as oxidation of the donor supply layer 13. intrusion of impurities, etc. For example, the InAlAs donor supply layer containing Al (aluminum) is so active that the formation of the Schottky electrode directly on the donor supply layer by the conventional methods easily causes oxidation with a result of deterioration of electric characteristics, such as decreases of drain current, but the first embodiment can solve such problem.

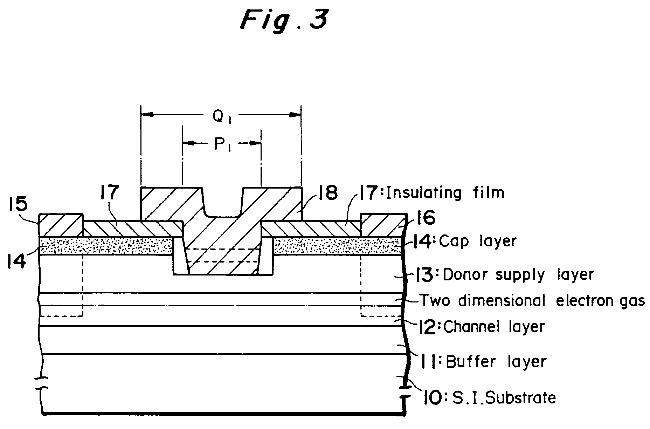

In the fourth step shown in Fig. 2D, the aqueous phosphoric acid solution and the hydrogen peroxide are used as etchant to form the recess structure having a tapered side wall as shown in Fig. 1. But, in the fourth step, etching gas with $CH_4 + H_2$ , instead of the above etchant, can be used to form the recess structure. The application of the etching gas with $CH_4 + H_2$ , as shown in Fig. 3, realizes the formation of a recess structure having a side wall substantially perpendicular to the laminated surface of the insulating layer 17 on the donor supplying layer 13 and the cap layer 14 at the position inside from an edge of the opening P1 of the insulating layer 17. By making the side wall of the recess structure to be substantially perpendicular to the laminated surface of the insulating layer 17, the side wall is surely spaced from the Schottky electrode 18 so that the interior space of the recess structure is perfectly shielded from outside ambient atmosphere.

In the first embodiment, the Schottky electrode 18 has been explained in terms of the prevention of oxidation and intrusion of impurities in connection with the vicinity of the portion where the Schottky electrode is formed on and the donor supply layer 13 in the recess structure. Further, this embodiment is effective to the prevention of oxidation of the Schottky electrode 18 itself.

The first embodiment has been explained by means of a HEMT, but is not limited to MESFET's and other compound semiconductor devices which have recess structures.

Further, the above can be applied to a compound semiconductor device except for a semiconductor device having an InP substrate, for example, a semiconductor device having a GaAs substrate.

Embodiment 2

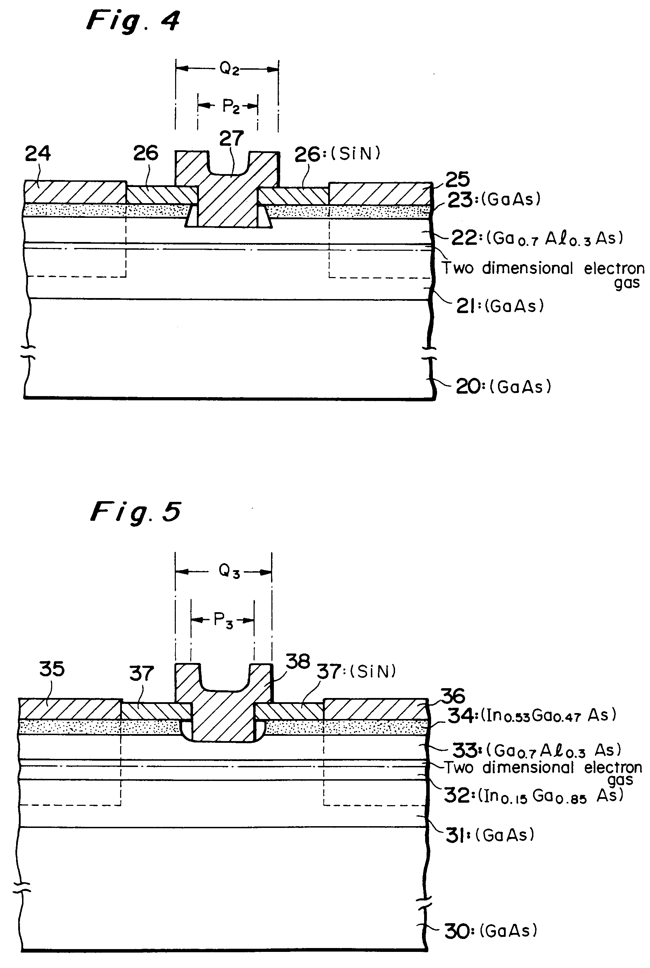

A second embodiment of this invention will be explained with reference to Fig. 4. Fig. 4 is a vertical sectional view of a major portion of the HEMT according to the second embodiment.

First, the structure of the HEMT will be explained. An undoped GaAs buffer layer 21 is formed in 3000 Å on a GaAs substrate 20. On the buffer layer 21 a donor supply layer 22 of $Ga_{0.7}Al_{0.3}As$ of a $1 \times 10^{18}/cm^3$ electron concentration is formed in 500 Å. On the donor supply layer 22 a GaAs cap layer 23 of a $5 \times 10^{18}/cm^3$ electron concentration is formed in 500 Å. Drain and source ohmic electrodes 24, 25 are vaporized on set regions on the cap layer 23, and a heavily doped n-type layer (indicated by the dot lines in Fig. 4) are formed by alloying below the ohmic electrodes 24, 25.

An insulating film 26 of SiN is formed in a thickness of about 500 Å - 1000 Å on the ohmic electrodes 24, 25, and on a rest portion of the cap layer 23 other than a set region thereof for a Schottky electrode 27 to be formed in. In the region for the Schottky electrode 27 to be formed in (a region between the drain and the source) the insulating film 26 is partially absent to define a rectangular opening P2, and a recess structure corresponding to the opening P2 and extended down to a portion of an upper portion of the donor supply layer 22 through the cap layer 23. The Schottky electrode 27 is formed by vacuum vaporization in the recess structure in contact with the donor supply layer 22. The Schottky electrode 27 is formed by vacuum vaporizing Ti/Pt/Au sequentially in respective 500 Å/500 Å/5000 Å thicknesses.

The Schottky electrode 27 partially contacts with the donor supply layer 22, and is extended upward through the opening P2 without contacting the side walls of the cap layer 23 to overlap on portions of the upper surface of the insulating film 26 outside the opening P2.

This HEMT is fabricated by the following fabrication process. This process will be explained in accordance with the steps (shown in Figs. 2A to 2D) of the fabrication process of the first embodiment. In the first step the buffer layer 21, the donor supply layer 22 and the cap layer 23 are formed in the stated order on the GaAs substrate 20 by molecular beam epitaxy (MBE) or organometallic vapor phase epitaxy (OMVPE).

Next, in the second step, drain and source ohmic electrodes 24, 25 are vaporized on set regions on the cap layer 23, and then a heavily doped n-type layer is formed below the ohmic electrodes 24, 25 by alloying. Then an SiN insulating film 26 is formed in an about 500 Å - 1000 Å thickness by plasma CVD. This SiN insulating film 26 can be formed at comparatively low temperatures, but insulating materials which can be formed at low temperatures than SiN, e.g., $SiO_2$, SiON, etc., may be used.

Then, in the third step, a portion of the insulating film 26 corresponding to the opening P2 is removed using a photoresist (corresponding to the photoresist FA in Fig. 2C) by the known photolithography. That is, this opening P2 functions as a mask for recess etching, and substantially defines a channel length and a width of a gate. After the formation of the opening P2, the photoresist is removed.

Subsequently, in the fourth step, a photoresist (corresponding to the photoresist FB in Fig. 2D) is applied to a rest portion of the insulating film 26 except a region Q2 which is larger and contains the opening P2 by the known photolithography. The formation of the photoresist is followed by recess etching the cap layer 23 down into the donor supply layer 22 with the insulating film 26 and the photoresist as a mask.

For the recess etching an enchant of citric acid aqueous solution and aqueous hydrogen peroxide is used. This recess etching forms a recess structure having the so-called inversely tapered side walls, which, as shown in Fig. 4, a space is transversely increased downward from the opening P2. That is, this recess structure makes a space in the cap layer 23 transversely larger than the opening P2 in the insulating film 26.

Then, Ti/Pt/Au are sequentially vacuum vaporized respectively in 500 Å/500 Å/5000 Å thicknesses so as to cover the opening P2 and the region Q2, and subsequently an unnecessary portion of the photoresist is lifted off, whereby the Schottky gate electrode 27 as shown in Fig. 3 is formed. Since this vacuum vaporization forms the Schottky electrode 27 in a rectangular sectional shape of the opening P2 in the insulating film 26, the Schottky gate electrode 27 is in contact with the donor supply layer 22 but out of contact with the cap layer 23, which is etched wider than the opening P2. The lift-off of the unnecessary portion of the photoresist permits the Schottky gate electrode 27 to be vaporized even on the region Q2 on the upper surface of the insulating film 26. Thus, the opening P2 is tightly closed by the overlapping Schottky gate electrode 27 on the upper surface of the insulating film 26, whereby an interior space of the recess structure is perfectly shielded from outside ambient atmosphere.

According to the second embodiment, as shown in Fig. 4, the Schottky gate electrode 27 is formed in contact with the donor supply layer 22 while covering a portion of the insulating film 26. Accordingly the Schottky gate electrode 27 itself shields the recess structure from the outside, so that causes for incurring deterioration of electric characteristics, such as oxidation of the donor supply layer 22 and intrusion of impurities can be expelled.

The second embodiment has been explained by means of HEMT but is not limited to HETMT's. This invention is applicable to MESFET's and other semiconductor devices having recess structures.

Third Embodiment

A third embodiment of this invention will be explained with reference to Fig. 5. Fig. 5 is a vertical sectional view of a major portion of a HEMT according to this embodiment.

First, the structure of the HEMT will be explained. An undoped GaAs buffer layer 31 is formed in 3000 Å on a GaAs substrate 30. Further a $Ga_{0.7}Al_{0.3}As$ donor supply layer 33 of a $5 \times 10^{18}/cm^3$ electron concentration is formed in 400 Å, and an $In_{0.53}Ga_{0.47}As$ cap layer 34 of a $5 \times 10^{18}/cm^3$ electron concentration is formed in 100 Å. Drain and source ohmic electrodes 35, 36 are formed by vacuum vaporization on set regions on the cap layer 34. A heavily doped n-type layer (indicated by the dot lines in Fig. 5) is formed by alloying below the ohmic electrodes 35, 36.

A SiN insulating film 37 is formed in an about 500 Å - 1000 Å thickness on the ohmic electrodes 35, 36, and on a rest portion of the cap layer 34 other than a region with a Schottky electrode 38 formed in. The insulating film 37 is absent in the region with the Schottky electrode formed in (a region between the drain and the source) to define a rectangular opening P3, and a recess structure which corresponds to the opening P3 and arrives at a portion of an upper portion of the donor supply layer 33 through the cap layer is formed. The Schottky gate electrode 38 is formed by vacuum vaporization in the recess structure in Schottky junction with the donor supply layer 33. The Schottky gate electrode 38 is formed by sequentially vacuum vaporizing Ti/Pt/Au.

The Schottky gate electrode 38 is in contact only with the donor supply layer 33, and extended upward without contacting the side walls of the cap layer 34 through the opening P3 to overlap portions of the upper surface of the insulating film 37.

The HEMT of this structure is fabricated by the following fabrication process. This fabrication process will be explained in accordance with the steps of the fabrication process of Figs. 2A to 2D according to the first embodiment. In the first step, the buffer layer 31, the channel layer 32 and the donor supply layer 33 and the cap layer 34 are formed on the GaAs substrate in the stated order in the above-described thicknesses by molecular beam epitaxy (MBE) and organic metallic vapor phase epitaxy (OMVPE).

Then, in the second step, the drain and source ohmic electrodes 35, 36 are formed by vacuum vaporization on the set regions, and then the heavily doped n-type layer is formed by alloying below the ohmic electrodes 35, 36. The SiN insulating film 37 is formed by plasma CVD in an about 500 Å - 1000 Å thickness. The SiN insulating film 37 can be comparatively low temperatures, but it is possible to use an insulating material which can be formed at a lower temperature than SiN, such as $SiO_2$ or SiON.

Next, in the third step, the region of the insulating film 37 for the opening P3 to be formed in is removed by the known photolithography using a photoresist (corresponding to the photoresist FA in Fig. 2C). The opening P3 functions as a mask for the recess etching and defines a channel length and channel width of a gate. The formation of the opening P3 is followed by removal of the photoresist.

Then, in the fourth step, a photoresist (corresponding to the photoresist FB in Fig. 2D) is applied to a rest portion of the insulating film 37 except a region Q3 which is larger and contains the opening P3 by the known photolithography. The formation of the photoresist is followed by recess etching the cap layer 34 down into the donor supply layer 33 with the insulating film 37 and the photoresist as a mask.

For the recess etching an etchant of aqueous sulfuric acid solution and aqueous hydrogen peroxide is used. As shown in Fig. 5, the recess structure corresponding to the opening P3 is formed in the donor supply layer 33, and the cap layer 34 is etched a little wider than the opening P3 in the insulating film 37. Accordingly a space formed by the recess structure in the cap layer 34 is wider than the opening P3 in the insulating film 37.

Then, Ti/Pt/Au are sequentially vacuum vaporized respectively in 500 Å/500 Å/5000 Å thicknesses so as to cover the opening P3 and the region Q3, and subsequently an unnecessary portion of the photoresist is lifted off, whereby the Schottky gate electrode 38 as shown in Fig. 5 is formed. Since this vacuum vaporization forms the Schottky electrode 38 in a rectangular sectional shape of the opening P3 in the insulating film 37, the Schottky gate electrode 37 is in contact with the donor supply layer 33 but out of contact with the cap layer 34, which is etched wider than the opening P3. The lift-off of the unnecessary portion of the photoresist permits the Schottky gate electrode 38 to be vaporized even on the region Q3 on the upper surface of the insulating film 37. Thus, the opening P3 is tightly closed by the overlapping Schottky gate electrode 38 on the upper surface of the insulating film 26, whereby an interior space of the recess structure is perfectly shielded from outside ambient atmosphere.

According to the second embodiment, as shown in Fig. 5, the Schottky gate electrode 38 is formed in contact with the donor supply layer 33 while covering a portion of the insulating film 37. Accordingly the Schottky gate electrode 38 itself shields the recess structure from the outside, so that causes for incurring deterioration of electric characteristics, such as oxidation of the donor supply layer 33 and intrusion of impurities can be expelled.

The second embodiment has been explained by means of HEMT but is not limited to HETMT's. This invention is applicable to MESFET's and other semiconductor devices having recess structures.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

**Claims**

1. A compound semiconductor device having a recess gate structure comprising:
   a cap layer (14; 23; 34) formed on a donor supply layer (13; 22; 33);
   an insulating layer (17; 26; 37) formed on the cap layer;
   an opening ($P_1$; $P_2$; $P_3$) formed in the insulating layer (17; 26; 37) corresponding to a gate forming region;
   a recess formed in a portion of the cap layer (14; 23; 34) corresponding to the opening ($P_1$; $P_2$; $P_3$) and extended into the donor supply layer (13; 22; 33), a space of the recess in the cap layer (14; 23; 34) being wider in the direction normal to the donor supply layer (13; 22; 33) than an open area of the opening ($P_1$; $P_2$; $P_3$); and

a Schottky gate electrode (18; 27; 38) formed directly on the donor supply layer (13; 22; 33) through the opening ($P_1$; $P_2$; $P_3$) and the recess, extended upward through the opening ($P_1$; $P_2$; $P_3$) without contacting the side walls of the cap layer (14; 23; 34) in the recess, and overlapped on a portion of an upper surface of the insulating layer (17; 26; 37).

2. A compound semiconductor device according to claim 1, wherein the recess is formed by etching with the insulating film (17; 26; 37) with the opening ($P_1$; $P_2$; $P_3$) as a mask.

3. A compound semiconductor device according to claim 1 or 2,
wherein the donor supply layer (13) is formed of $In_xAl_yAs$ (where $x + y = 1$; $0 < x$; $0 < y$) and the cap layer (14) is formed of $In_mGa_nAs$ (where $m + n = 1$; $0 < m$; $0 < n$).

4. A compound semiconductor device according to claim 1 or 2,
wherein the donor supply layer (22) is formed of $Ga_sAl_tAs$ (where $s + t = 1$; $0 < s$; $0 < t$) and the cap layer (23) is formed of GaAs.

5. A compound semiconductor device according to claim 1 or 2,
wherein the donor supply layer (33) is formed of $Ga_\alpha Al_\beta As$ (wherein $\alpha + \beta = 1$; $0 < \alpha$; $0 < \beta$), and the cap layer (34) is formed of $In_\gamma Ga_\delta As$ (where $\gamma + \delta = 1$; $0 < \gamma$; $0 < \delta$).

6. A compound semiconductor device according to any of claims 1 to 5,
wherein the insulating film (17; 26; 37) is formed of SiN.

7. A method for fabricating a compound semiconductor device having a recess structure comprising:
forming a cap layer (14; 23; 34) on a donor supply layer (13; 22; 33), and forming an insulating film (17; 26; 37) with an opening ($P_1$; $P_2$; $P_3$) in a portion thereof;

etching the cap layer (14; 23; 34) through the opening ($P_1$; $P_2$; $P_3$) to form a recess extended into the donor supply layer (13; 22; 33) and having a space extended wider than an area of the opening ($P_1$; $P_2$; $P_3$); and

forming by vacuum vaporization a Schottky gate electrode (18; 27; 38) which is in Schottky junction with the donor supply layer (13; 22; 33) in the recess, extended upward through the opening ($P_1$; $P_2$; $P_3$), and overlapped on a portion of an upper surface of the insulating film (17; 26; 37).

# Fig. I

15  17  18  1.0μm  P₁  17  16

Q₁

P₁  0.5 μm

17  18  17: Insulating film

15  16

14  14: Cap layer

13: Donor supply layer

Two dimensional electron gas

12: Channel layer

11: Buffer layer

10: S.I. Substrate

*Fig.2A*

14: (In$_{0.53}$Ga$_{0.47}$ As)
13: (In$_{0.52}$Al$_{0.48}$ As)
Two dimensional electron gas
12: (InGaAs)
11: (InAlAs), (InP)
10: (S.I.InP)

*Fig.2B*

17: (SiN)
15
16
14
13
12
11
10

*Fig.2C*

FA        FA
17              17
15              16
                14
                13
                12
                11
                10

*Fig.2D*

FB  17    Q$_1$    17  FB
        P$_1$
15              16
                14
                13
                12
                11
                10

# Fig.3

15 17 18 17:Insulating film

16

14:Cap layer

14 13:Donor supply layer

Two dimensional electron gas

12:Channel layer

11:Buffer layer

10:S.I.Substrate

**Fig. 4**

$Q_2$, $P_2$, 24, 26, 27, 26:(SiN), 25, 23:(GaAs), 22:($Ga_{0.7}Al_{0.3}As$), Two dimensional electron gas, 21:(GaAs), 20:(GaAs)

**Fig. 5**

$Q_3$, $P_3$, 35, 37, 38, 37:(SiN), 36, 34:($In_{0.53}Ga_{0.47}As$), 33:($Ga_{0.7}Al_{0.3}As$), Two dimensional electron gas, 32:($In_{0.15}Ga_{0.85}As$), 31:(GaAs), 30:(GaAs)

11

Fig.6

Two dimensional electron gas